# EUROPEAN PATENT APPLICATION

(11) **EP 4 676 200 A2**
(43) Date of publication of application: **07.01.2026**
(21) Application number: 25172559.4
(22) Date of filing: 25.04.2025
(51) Int. Cl.: H10K 59/122, H10K 59/80

(54) **DISPLAY DEVICE, METHOD OF MANUFACTURING DISPLAY DEVICE, AND ELECTRONIC DEVICE COMPRISING DISPLAY DEVICE**

(30) Priority: 14.06.2024 KR 20240077644
(71) Applicant: Samsung Display Co., Ltd., Yongin-si, Gyeonggi-do 17113 (KR)
(72) Inventor: Park, Jee Hoon, Yongin-si, Gyeonggi-do 17113 (KR); Kim, Jae Hoon, Yongin-si, Gyeonggi-do 17113 (KR); Hwang, Jae Kwon, Yongin-si, Gyeonggi-do 17113 (KR)
(74) Representative: Gulde & Partner

(57) **Abstract**

A display device, a method of manufacturing the display device, and an electronic device comprising the display device are provided. The display device includes a base layer which is disposed across a display area and a non-display area of the display device; a light-emitting element which is disposed on the base layer in the display area and includes an anode electrode, a cathode electrode, and a light-emitting part electrically connected between the anode electrode and the cathode electrode; a first pixel definition layer and a second pixel definition layer which are disposed on the base layer in the display area; and a dummy dam which is disposed on the base layer in the non-display area and surrounds at least a portion of the display area. The first pixel definition layer extends in a first direction, and the second pixel definition layer extends in a second direction different from the first direction.

## Description

This application claims priority to Korean Patent Application No. 10-2024-0077644, filed on June 14, 2024, and all the benefits accruing therefrom, the content of which in its entirety is herein incorporated by reference.

### BACKGROUND

### 1. Field

The present disclosure relates to a display device, a method of manufacturing the display device, and an electronic device comprising the display device.

### 2. Description of the Related Art

In recent years, with the increased interest in information displays, research and development of display devices has been carried out continuously.

A display device may include a light-emitting element including an anode electrode and a cathode electrode. The cathode electrode may be electrically connected to another wiring to receive a cathode signal. The cathode electrode and the wiring electrically connected to the cathode electrode may be patterned to suit the overall area of the display device.

### SUMMARY

One aspect of the present disclosure is to provide a display device, a method of manufacturing the display device, and an electronic device comprising the display device having improved display quality.

One aspect of the present disclosure is to provide a display device, a method of manufacturing the display device, and an electronic device comprising the display device, wherein process precision is improved and process efficiency is improved.

According to an embodiment of the present disclosure, a display device including a display area and a non-display area may be provided. The display device may include a base layer which is disposed across the display area and the non-display area; a light-emitting element which is disposed on the base layer in the display area and includes an anode electrode, a cathode electrode, and a light-emitting part electrically connected between the anode electrode and the cathode electrode; a first pixel definition layer and a second pixel definition layer which are disposed on the base layer in the display area; and a dummy dam which is disposed on the base layer in the non-display area and surrounds at least a portion of the display area. The first pixel definition layer may extend in a first direction, and the second pixel definition layer may extend in a second direction different from the first direction. The light-emitting part may be disposed in an area surrounded by the first pixel definition layer and the second pixel definition layer. A cross-section of the second pixel definition layer may have a reverse-tapered shape. A cross-section of the dummy dam may have a normal-tapered shape.

According to an embodiment, the display device may include a first pixel and a second pixel which are adjacent to each other along the second direction, wherein each of the first pixel and the second pixel includes the light-emitting element. Each of the first pixel and the second pixel may include a first sub-pixel area in which light of a first color is provided, a second sub-pixel area in which light of a second color is provided, and a third sub-pixel area in which light of a third color is provided. The first sub-pixel area, the second sub-pixel area, and the third sub-pixel area may be adjacent to the second pixel definition layer in the first direction. The first sub-pixel area of the first pixel and the first sub-pixel area of the second pixel may be adjacent to each other in the second direction. The second sub-pixel area of the first pixel and the second sub-pixel area of the second pixel may be adjacent to each other in the second direction. The third sub-pixel area of the first pixel and the third sub-pixel area of the second pixel may be adjacent to each other in the second direction.

According to an embodiment, the dummy dam may entirely surround the display area.

According to an embodiment, the dummy dam and the second pixel definition layer may include a same material.

According to an embodiment, the dummy dam, the first pixel definition layer, and the second pixel definition layer may include an organic material.

According to an embodiment, the display device may further include a first cathode connection line which is disposed in the non-display area and comprises a same material as the anode electrode.

According to an embodiment, the display device may further include a second cathode connection line, which includes a same material as the cathode electrode, covers the dummy dam, and is electrically connected to the first cathode connection line.

According to an embodiment, the cathode electrode and the second cathode connection line may be integral with each other.

According to an embodiment, the display area may be formed on one side of the dummy dam. The first cathode connection line may be formed on the other side of the dummy dam.

According to an embodiment, a cross-section of the first pixel definition layer may have a normal-tapered shape.

According to an embodiment of the present disclosure, a display device including a display area and a non-display area may be provided. The display device may include a base layer which is disposed across the display area and the non-display area; a light-emitting element which is disposed on the base layer in the display area and includes an anode electrode, a cathode electrode, and a light-emitting part electrically connected between the anode electrode and the cathode electrode; a first pixel definition layer and a second pixel definition layer which are disposed on the base layer in the display area; and a dummy dam which is disposed on the base layer in the non-display area and surrounds at least a portion of the display area; and a connecting pattern layer which covers a side surface and an upper surface of the dummy dam. The first pixel definition layer may extend in a first direction, and the second pixel definition layer extends in a second direction different from the first direction. The light-emitting part may be disposed in an area surrounded by the first pixel definition layer and the second pixel definition layer. A cross-section of the first pixel definition layer may have a normal-tapered shape. A cross-section of the second pixel definition layer may have a reverse-tapered shape. A cross-section of the dummy dam may have a reverse-tapered shape. A cross-section of the connecting pattern layer may have a normal-tapered shape.

A method of manufacturing a display device according to an embodiment of the present disclosure may include patterning an anode electrode, a first cathode connection line, and a first pixel definition layer extending in a first direction on a base layer; patterning a second pixel definition layer extending in a second direction different from the first direction and a dummy dam; forming a light-emitting part in an area surrounded by the second pixel definition layer using an inkjet process; and forming a cathode electrode and a second cathode connection line. The forming of the cathode electrode and the second cathode connection line may include: covering, by the second cathode connection line, the dummy dam entirely; and forming the second cathode connection line and the cathode electrode integrally with each other.

According to an embodiment, the patterning of the second pixel definition layer and the dummy dam may include performing an exposure process using a photomask including a full tone part and a middle part. A position of the full tone part may correspond to a position of the second pixel definition layer. A position of the middle part may correspond to a position of the dummy dam.

According to an embodiment, the performing of the exposure process includes forming a photoresist layer including a negative type photoresist.

According to an embodiment, a cross-section of the dummy dam may have a normal-tapered shape.

According to an embodiment, a cross-section of the first pixel definition layer may have a normal-tapered shape. A cross-section of the second pixel definition layer may have a reverse-tapered shape.

According to an embodiment, the patterning of the second pixel definition layer may include patterning a plurality of second pixel definition layers spaced apart in the first direction. The forming of the light-emitting part may include providing ink including material associated with forming the light-emitting part between the plurality of second pixel definition layers.

According to an embodiment, the forming of the second cathode connection line may include disposing the second cathode connection line such that the second cathode connection line is directly adjacent to the dummy dam.

According to an embodiment, the forming of the cathode electrode may include disposing the cathode electrode such that the cathode electrode is directly adjacent to the first pixel definition layer.

According to an embodiment, the patterning of the first cathode connection line and the forming of the cathode electrode and the second cathode connection line may include forming, by the cathode electrode, the first cathode connection line, and the second cathode connection line, a cathode signal path.

An electronic device according to an embodiment of the present disclosure, may comprise: a processor configured to provide input image data; a display device configured to display an image based on the input image data; and a power supply configured to supply power to the display device. The display device may comprise a display area and a non-display area. The display device may comprise: a base layer which is disposed across the display area and the non-display area; a light-emitting element which is disposed on the base layer in the display area and comprises an anode electrode, a cathode electrode, and a light-emitting part electrically connected between the anode electrode and the cathode electrode; a first pixel definition layer and a second pixel definition layer which are disposed on the base layer in the display area; and a dummy dam which is disposed on the base layer in the non-display area and surrounds at least a portion of the display area. The first pixel definition layer may extend in a first direction, and the second pixel definition layer may extend in a second direction different from the first direction. The light-emitting part may be disposed in an area surrounded by the first pixel definition layer and the second pixel definition layer. A cross-section of the second pixel definition layer may have a reverse-tapered shape. A cross-section of the dummy dam may have a normal-tapered shape.

According to embodiments of the present disclosure, it is possible to provide a display device, a method of manufacturing the display device, and an electronic device comprising the display device, wherein a cathode signal path may be clearly formed.

According to embodiments of the present disclosure, it is possible to provide a display device, a method of manufacturing the display device, and an electronic device comprising the display device having improved display quality.

According to embodiments of the present disclosure, it is possible to provide a display device, a method of manufacturing the display device, and an electronic device comprising the display device, wherein process precision is improved and process efficiency is improved.

### BRIEF DESCRIPTION OF THE DRAWINGS

FIG. 1 is a schematic plan view illustrating a display device according to an embodiment.
FIG. 2 is a schematic cross-sectional diagram illustrating a display device according to an embodiment.
FIG. 3 is a schematic plan view illustrating a display device according to an embodiment.
FIG. 4 is a schematic plan view illustrating an inkjet printing process for forming a light-emitting part.
FIGS. 5 and 6 are schematic cross-sectional diagrams illustrating a display device according to a first embodiment.
FIGS. 7 and 8 are schematic cross-sectional diagrams illustrating a display device according to a second embodiment.
FIG. 9 is a flowchart illustrating a method of manufacturing the display device according to the first embodiment.
FIGS. 10 to 17 are schematic cross-sectional diagrams for respective process steps illustrating a method of manufacturing the display device according to the first embodiment.
FIG. 18 is a flowchart illustrating a method of manufacturing the display device according to the second embodiment.
FIGS. 19 to 26 are schematic cross-sectional diagrams for respective process steps illustrating a method of manufacturing the display device according to the second embodiment.
FIG. 27 is a schematic block diagram illustrating an electronic device including a display device in accordance with an embodiment.
FIG. 28 is a schematic diagram illustrating an example where the electronic device of FIG. 27 is implemented as a smartphone.
FIG. 29 is a schematic diagram illustrating an example where the electronic device of FIG. 27 is implemented as a tablet computer.

### DETAILED DESCRIPTION

The present disclosure may be variously altered and may take many forms, and specific embodiments are illustrated in drawings and described in detail in the present disclosure. However, it is not intended to limit the present disclosure to any particular form of disclosure and should be understood to include all changes, equivalents or substitutions that fall in the scope of thought and technology of the present disclosure.

Terms such as, for example, first and second may be used to describe various components, but the components should not be limited by the above terms. The above terms are used for the purpose of distinguishing one component from another and are not to be limited. For example, a first component may be named a second component without going beyond the scope of rights of the present disclosure, and similarly, the second component may be named the first component. Singular expressions include plural expressions, unless the context clearly means otherwise.

In the present disclosure, the terms "comprise", "include" or "have" shall be understood to designate the existence of a feature, a number, a step, an action, a component, a part, or a combination thereof set forth in the present disclosure, and shall be understood not to preclude the possibility of the existence or addition of one or more other features or numbers, steps, motions, components, parts, or combinations thereof. In some aspects, when a part such as, for example, a layer, a film, an area, or a plate is referred to as being "on" another part, this includes not only the case where the part is "directly on top" of the other part, but also the case where there is another part in between. In some aspects, in the present specification, when a part such as, for example, a layer, a film, an area, or a plate is referred to as being formed on another part, the direction in which the part is formed is not limited to an upward direction, but includes formation in a lateral or downward direction. Conversely, when a part such as, for example, a layer, a film, an area, or a plate is referred to as being "below" another part, this includes not only the case where the part is "just below" the other part, but also the case where there is still another part in between.

The term "substantially," as used herein, means approximately or actually. The term "substantially equal" means approximately or actually equal. The term "substantially the same" means approximately or actually the same. The term "substantially identically" means approximately or actually identically.

The present disclosure relates to a display device, a method of manufacturing of the display device, and an electronic device comprising the display device. Hereinafter, a display device, a method of manufacturing the display device, and an electronic device comprising the display device will be described with reference to the accompanying drawings.

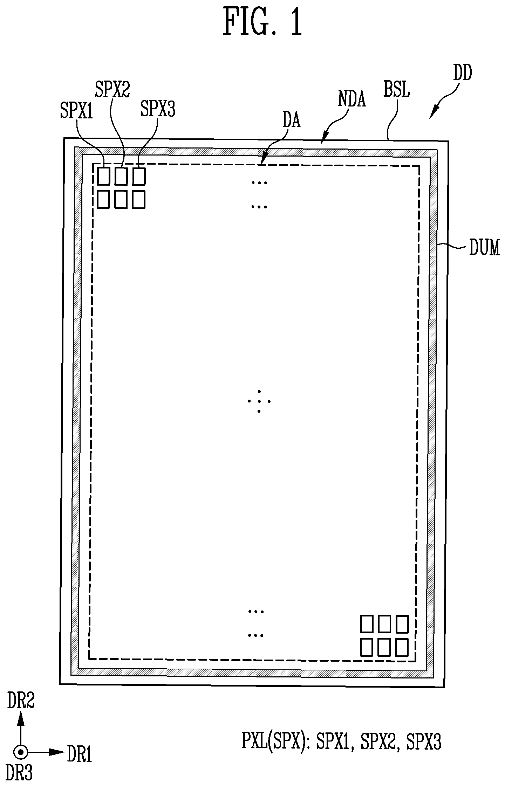

FIG. 1 is a schematic plan view illustrating a display device according to an embodiment.

Referring to FIG. 1, a display device DD includes a base layer BSL and pixels PXL disposed on the base layer BSL. The display device DD may further include a dummy dam DUM. The display device DD may further include a driving circuit unit (e.g., a scan driving unit and a data driving unit) for driving pixels PXL, wirings, and pads.

The display device DD (or base layer BSL) may include a display area DA and a non-display area NDA. The non-display area NDA may refer to an area except the display area DA. The non-display area NDA may surround at least a portion of the display area DA.

The base layer BSL may form a base surface of the display device DD. The base layer BSL may be disposed across the display area DA and the non-display area NDA. According to embodiments, the base layer BSL may be a lower substrate for disposing layers which form the display device DD. The base layer BSL may be a rigid or flexible substrate or film. For example, the base layer BSL may include a glass material. Alternatively, the base layer BSL may include a silicone material. Alternatively, the base layer BSL may include polyimide. However, embodiments of the present disclosure are not limited thereto.

A plane defined herein may be defined based on the plane on which the base layer BSL is disposed, as a plane extending in a first direction DR1 and a second direction DR2. According to embodiments, a third direction DR3 may be the thickness direction of the base layer BSL, and the third direction DR3 may be the light emission direction of the display device DD.

The display area DA may refer to an area where pixels PXL are disposed. The non-display area NDA may refer to an area where pixels PXL are not disposed. A driving circuit unit, wirings, and pads, which are connected to the pixels PXL of the display area DA, may be disposed in the non-display area NDA.

The dummy dam DUM may be disposed in the non-display area NDA. The dummy dam DUM may be disposed on the periphery of the display area DA. The dummy dam DUM may surround at least a portion of the display area DA. According to embodiments, the dummy dam DUM may entirely surround the display area DA. For example, the dummy dam DUM may have a closed-loop shape. However, embodiments of the present disclosure are not limited thereto.

The dummy dam DUM may be a dam structure and may protrude in the thickness direction of the base layer BSL (e.g., in the third direction DR3).

The dummy dam DUM may reduce the risk of inks drying excessively during the inkjet printing process to form certain configurations in the display area DA. In some aspects, according to embodiments, the dummy dam DUM is patterned to correspond to the position of the display area DA, such that the position of the display area DA may be roughly defined.

According to an embodiment, the pixels PXL (or sub-pixels SPX) may be arranged according to a stripe or PENTILE^{™} / PENTILE^{®} array structure, but are not limited thereto, and various forms of embodiments may be applied to the present disclosure.

According to an embodiment, the pixels PXL (or sub-pixels SPX) may include a first sub-pixel SPX1, a second sub-pixel SPX2, and a third sub-pixel SPX3. Each of the first sub-pixel SPX1, the second sub-pixel SPX2, and the third sub-pixel SPX3 may be a sub-pixel. At least one first sub-pixel SPX1, at least one second sub-pixel SPX2, and at least one third sub-pixel SPX3 may form a single pixel unit capable of emitting light of various colors.

Each of the first sub-pixel SPX1, the second sub-pixel SPX2, and the third sub-pixel SPX3 may emit a single color of light.

For example, the first sub-pixel SPX1 may be a red pixel that emits light of red (e.g., a first color), the second sub-pixel SPX2 may be a green pixel that emits light of green (e.g., a second color), and the third sub-pixel SPX3 may be a blue pixel that emits light of blue (e.g., a third color). The red pixel may provide light in a wavelength band of 600 nm to 750 nm. The green pixel may provide light in a wavelength band from 480 nm to 560 nm. The blue pixel may provide light in a wavelength band of 370 nm to 460 nm.

According to an embodiment, the number of second sub-pixels SPX2 may be greater than the number of first sub-pixels SPX1 and the number of third sub-pixels SPX3. However, the color, the type, and/or the number of the first sub-pixels SPX1, the second sub-pixels SPX2, and the third sub-pixels SPX3, which form each pixel unit, are not limited to specific examples.

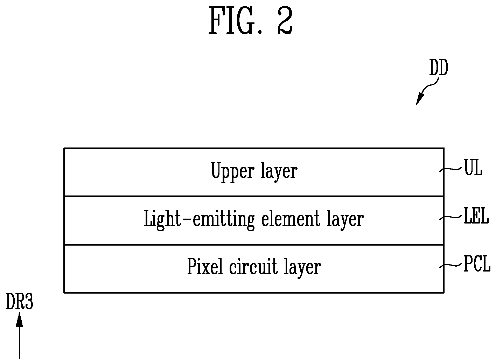

FIG. 2 is a schematic cross-sectional view illustrating a display device according to an embodiment.

Referring to FIG. 2, the display device DD may include a pixel circuit layer PCL and a light-emitting element layer LEL. The display device DD may further include an upper layer UL.

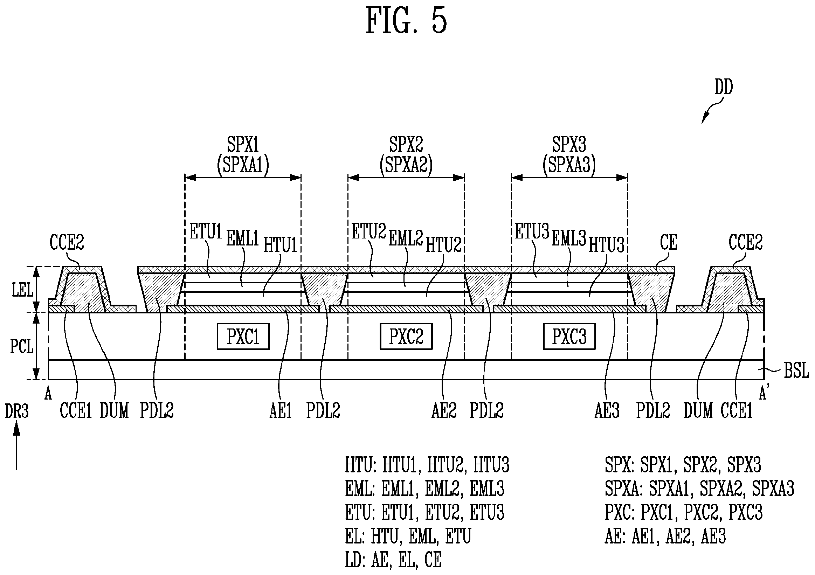

The pixel circuit layer PCL may include a base layer BSL. The pixel circuit layer PCL may be a layer including a pixel circuit PXC (see FIG. 5). The pixel circuit layer PCL may be a backplane layer. The pixel circuit PXC may be formed on a base layer BSL and configured to drive a light-emitting element LD (see FIG. 5). The pixel circuit layer PCL may include conductive layers and insulating layers, and the conductive layers may form the pixel circuit PXC. The pixel circuit PXC may include circuit elements. The circuit elements may include a driving transistor and may also include additional transistors and capacitors.

The light-emitting element layer LEL may be disposed on the pixel circuit layer PCL. The light-emitting element layer LEL may be a layer from which light is provided and may include a light-emitting element LD.

The upper layer UL may be disposed on the light-emitting element layer LEL. The upper layer UL may include various light-transmitting layer(s), such as, for example, a cover window. According to embodiments, the upper layer UL may include a color filter, may include a range array layer, and may include a polarizing layer. However, the present disclosure is not limited to specific examples.

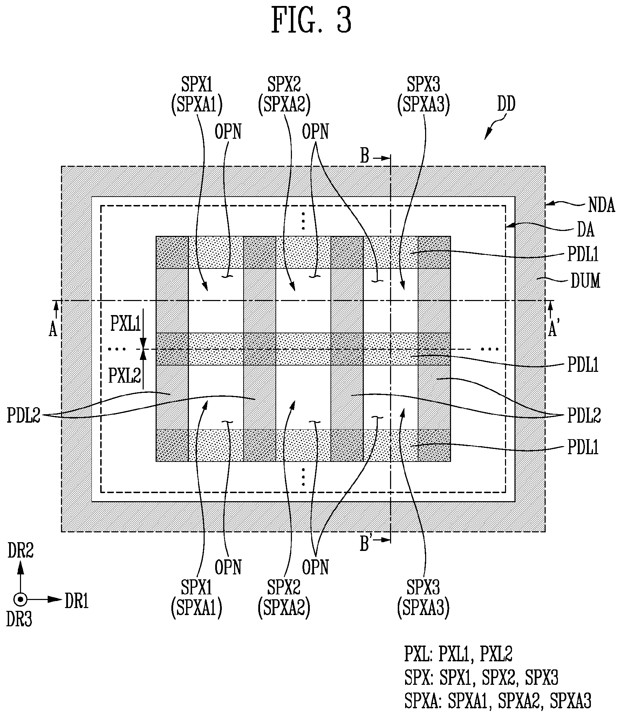

Referring to FIGS. 3 to 8, a display device DD including a dummy dam DUM, a first pixel definition layer PDL1, and a second pixel definition layer PDL2 according to an embodiment will be described.

FIG. 3 is a schematic plan view illustrating a display device according to an embodiment.

FIG. 3 is a schematic planar structure of the display device DD, illustrating a display area DA and a non-display area NDA in which a dummy dam DUM is disposed around the display area DA.

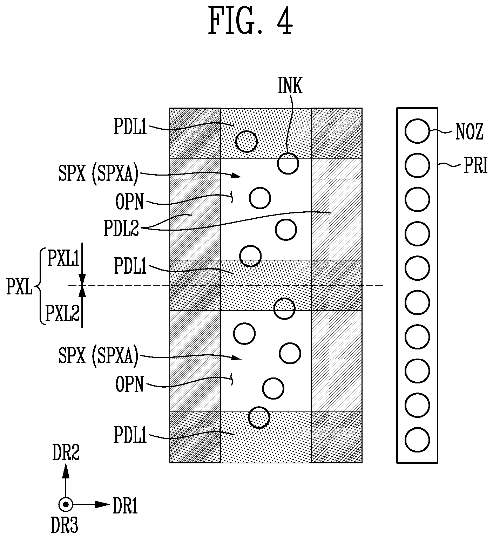

FIG. 4 is a schematic plan view illustrating an inkjet printing process supportive of forming a light-emitting part. FIG. 4 illustrates first and second pixels PXL1 and PXL2 adjacent to each other.

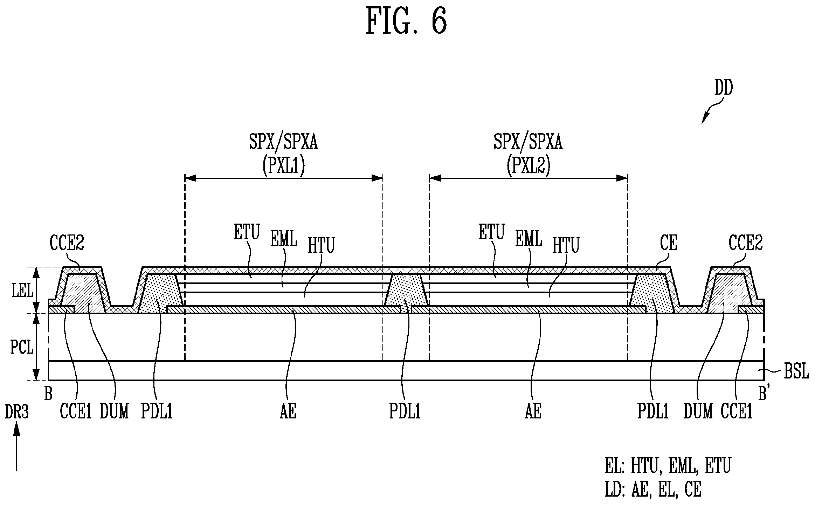

FIGS. 5 and 6 are schematic cross-sectional views illustrating a display device according to a first embodiment. FIG. 5 is a schematic cross-sectional view along line A~A' of FIG. 3. FIG. 6 is a schematic cross-sectional view along line B~B' of FIG. 3.

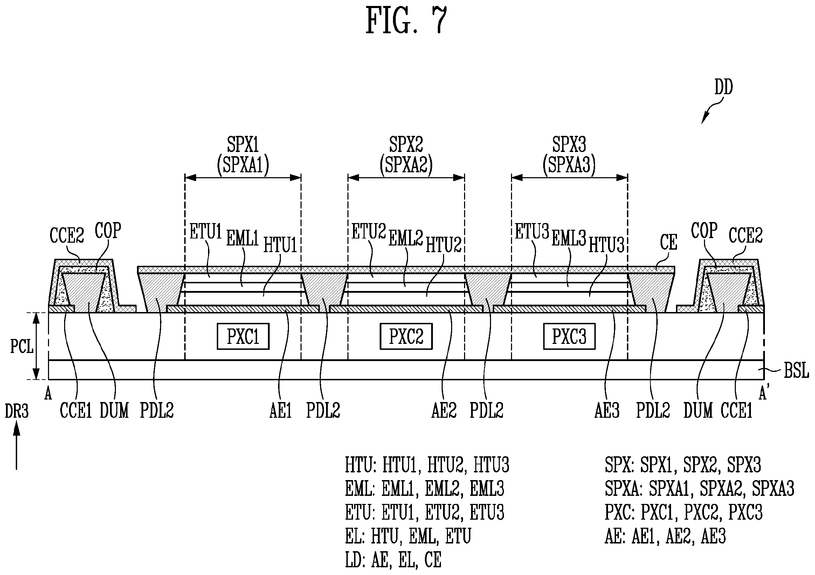

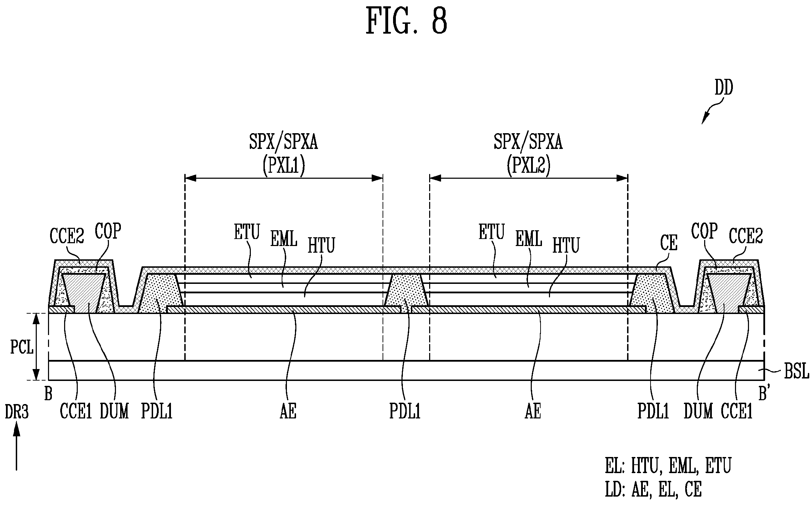

FIGS. 7 and 8 are schematic cross-sectional views illustrating a display device according to a second embodiment. FIG. 7 is a schematic cross-sectional view along line A~A' of FIG. 3. FIG. 8 is a schematic cross-sectional view along line B~B' of FIG. 3.

First, the display device DD according to the first embodiment will be described with reference to FIGS. 3 to 6.

Referring to FIGS. 3 to 6, the display device DD may include pixels PXL, a first pixel definition layer PDL1, and a second pixel definition layer PDL2 in the display area DA, and may include a dummy dam DUM in the non-display area NDA.

The pixel PXL includes a plurality of pixels. For example, the pixel PXL may include a first pixel PXL1 and a second pixel PXL2 that are adjacent to each other. According to an embodiment, the first pixel PXL1 and the second pixel PXL2 may be adjacent in a second direction DR2.

The pixel PXL may include sub-pixels SPX that include first to third sub-pixels SPX1 to SPX3. The sub-pixels SPX may form a sub-pixel area SPXA. The sub-pixel area SPXA may be an area where single-color light is emitted. For example, the sub-pixel area SPXA may include a first sub-pixel area SPXA1 which is formed by the first sub-pixel SPX1 and from which light of the first color is provide, a second sub-pixel area SPXA2 which is formed by the second sub-pixel SPX2 and from which light of the second color is provided, and a third sub-pixel area SPXA3 which is formed by a third sub-pixel SPX3 and from which light of the third color is provided.

According to embodiments, the sub-pixels SPX that provide light of a same color of each of the first pixel PXL1 and the second pixel PXL2 may be adjacent to each other along the direction in which the second pixel definition layer PDL2 extends (e.g., the second direction DR2).

For example, the first sub-pixel SPX1 (or the first sub-pixel area SPXA1) of the first pixel PXL1 and the first sub-pixel SPX1 (or the first sub-pixel area SPXA1) of the second pixel PXL2 may be adjacent along the second direction DR2. The second sub-pixel SPX2 (or the second sub-pixel area SPXA2) of the first pixel PXL1 and the second sub-pixel SPX2 (or the second sub-pixel area SPXA2) of the second pixel PXL2 may be adjacent along the second direction DR2. The third sub-pixel SPX3 (or the third sub-pixel area SPXA3) of the first pixel PXL1 and the third sub-pixel SPX3 (or the third sub-pixel area SPXA3) of the second pixel PXL2 may be adjacent along the second direction DR2.

The first pixel definition layer PDL1 may extend along the first direction DR1 in the display area DA. The first pixel definition layer PDL1 may be formed in multiple pieces, and the first pixel definition layers PDL1 may be disposed along the second direction DR2.

The first pixel definition layer PDL1 may protrude in the thickness direction of the base layer BSL (e.g., the third direction DR3).

The second pixel definition layer PDL2 may extend in a different direction from the first pixel definition layer PDL1. The second pixel definition layer PDL2 may extend along the second direction DR2 in the display area DA. The second pixel definition layer PDL2 may be formed in multiple pieces, and the second pixel definition layers PDL2 may be disposed along the first direction DR1.

The second pixel definition layer PDL2 may protrude in the thickness direction of the base layer BSL (e.g., the third direction DR3).

The first pixel definition layer PDL1 and the second pixel definition layer PDL2 may surround one area and form an opening OPN. For example, the first pixel definition layer PDL1 and the second pixel definition layer PDL2 may be disposed around one area, each surrounding different directions. The first pixel definition layer PDL1 and the second pixel definition layer PDL2 may have a protruding structure.

The area surrounded by the first pixel definition layer PDL1 and the second pixel definition layer PDL2 may correspond to the sub-pixel area SPXA. For example, a light-emitting part EL may be disposed in the area surrounded by the first pixel definition layer PDL1 and the second pixel definition layer PDL2, and the sub-pixel area SPXA may be formed.

According to embodiments, the sub-pixel area SPXA may be adjacent to the second pixel definition layer PDL2 along the first direction DR1. For example, each of the first to third sub-pixel areas SPXA1 to SPXA3 may be adjacent to the second pixel definition layer PDL2 along the first direction DR1.

The first pixel definition layer PDL1 and the second pixel definition layer PDL2 may be patterned in different processes and may be disposed in different layers. For example, the second pixel definition layer PDL2 may be patterned after the first pixel definition layer PDL1 is patterned.

The dummy dam DUM may be disposed in the non-display area NDA and disposed to surround the display area DA.

The dummy dam DUM may include a same material as the second pixel definition layer PDL2. For example, the dummy dam DUM may be patterned in a same process as the second pixel definition layer PDL2.

The first pixel definition layer PDL1, the second pixel definition layer PDL2, and the dummy dam DUM may include an insulating material. For example, the first pixel definition layer PDL1, the second pixel definition layer PDL2, and the dummy dam DUM may include an organic material. The organic material may include one or more of an acrylic resin, an epoxy resin, a phenol resin, a polyamide resin, and a polyimide resin. However, embodiments of the present disclosure are not limited thereto.

According to embodiments, the light-emitting part EL may be formed using an inkjet printing process. For example, the first pixel definition layer PDL1 and the second pixel definition layer PDL2 may form an opening OPN and have liquid repellency. Accordingly, the light-emitting part EL may be suitably provided in the opening OPN using the inkjet printing process.

According to embodiments, the opening OPN, which is an area where the light-emitting part EL is provided based on the inkjet printing process, may be defined by first and second pixel definition layers PDL1 and PDL2 extending in a predetermined direction, respectively, and in this case, a display device DD having improved display quality and improved process precision and process efficiency may be provided. This is explained in connection with FIG. 4.

According to an embodiment, ink INK including a material supportive of forming the light-emitting part EL may be provided using a printing device PRI including a nozzle part NOZ. The printing device PRI may be a device configured to discharge a fluid such as, for example, ink INK.According to embodiments, the nozzle part NOZ may be formed in plural, and the nozzle parts NOZ may be sequentially disposed along the second direction DR2.

As described herein, the sub-pixels SPX of each of the different pixels PXL adjacent to each other along the direction in which the second pixel definition layer PDL2 extends may provide light of a same color. Accordingly, an area where ink INK is provided may be defined by the second pixel definition layer PDL2 and may extend along the second direction DR2.

That is, the area where ink INK is provided may be formed across the first pixel PXL1 and the second pixel PXL2, and an operation activation rate of nozzle parts NOZ of the printing device PRI may be high during the inkjet printing process. For example, experimentally, when the target areas to which ink INK is supplied are not formed continuously but are spaced apart from each other, the nozzle parts NOZ corresponding to the intermediate area between the target areas need not operate during the inkjet printing process. However, according to an embodiment, since the target areas to which ink INK is supplied are formed continuously along the second direction DR2, the inactivity ratio of the nozzle part NOZ is reduced, and as a result, the process efficiency may be improved.

In some aspects, since the activity ratio of the nozzle parts NOZ is high during the inkjet printing process, the amount of ink INK may be controlled more clearly. Accordingly, the process precision is improved, and since the amount of material forming the light-emitting part EL for each sub-pixel SPX is appropriately controlled, the light-emitting uniformity may be improved. Accordingly, a display device DD with improved display quality may be provided by reducing risks such as, for example, stains.

Referring to FIGS. 5 and 6, the cross-sectional structure of the display device DD will be described.

According to an embodiment, the pixel circuit layer PCL may include a base layer BSL and a pixel circuit PXC on the base layer BSL. The pixel circuit PXC may include a first pixel circuit PXC1 that drives the first sub-pixel SPX1 (or a light-emitting element LD of the first sub-pixel SPX1), a second pixel circuit PXC2 that drives the second sub-pixel SPX2 (or a light-emitting element LD of the second sub-pixel SPX2), and a third pixel circuit PXC3 that drives the third sub-pixel SPX3 (or a light-emitting element LD of the third sub-pixel SPX3).

The light-emitting element layer LEL is disposed on the pixel circuit layer PCL and may include an anode electrode AE, a light-emitting part EL, a cathode electrode CE, a first cathode connection line CCE1, a first pixel definition layer PDL1, a second pixel definition layer PDL2, a dummy dam DUM, and a second cathode connection line CCE2.

The anode electrode AE may be disposed on the pixel circuit layer PCL. The anode electrode AE may include a first anode electrode AE1 disposed in the first sub-pixel area SPXA1 and forming the light-emitting element LD of the first sub-pixel SPX1, a second anode electrode AE2 disposed in the second sub-pixel area SPXA2 and forming the light-emitting element LD of the second sub-pixel SPX2, and a third anode electrode AE3 disposed in the third sub-pixel area SPXA3 and forming the light-emitting element LD of the third sub-pixel SPX3. The anode electrode AE may include various conductive materials. For example, the anode electrode AE may include a reflective metal, or may include a transparent conductive material.

The light-emitting part EL may be electrically connected between the cathode electrode CE and the anode electrode AE. The light emitting part EL may include a plurality of layers. For example, the light-emitting part EL may include a plurality of layers including a hole transport unit HTU, a light-emitting layer EML (or light generating layer), and an electron transport unit ETU. Each of the layers forming the light-emitting parts EL may include an organic material, and according to embodiments, may further include an inorganic material such as, for example, a metal-containing compound or a quantum dot.

The hole transport unit HTU may include a multilayer structure having a plurality of layers each including different materials. For example, the hole transport unit HTU may include a hole injection layer and a hole transport layer, and according to embodiments, may further include a light-emitting auxiliary layer and an electron blocking layer.

The hole transport unit HTU may include a first hole transport unit HTU1 disposed in the first sub-pixel area SPXA1 and forming the first sub-pixel SPX1, a second hole transport unit HTU2 disposed in the second sub-pixel area SPXA2 and forming the second sub-pixel SPX2, and a third hole transport unit HTU3 disposed in the third sub-pixel area SPXA3 and forming the third sub-pixel SPX3.

The light-emitting layer EML may include a material capable of emitting light of a single color. The light-emitting layer EML may include a host and a dopant. The host of the light-emitting layer EML is a luminescent material capable of capturing carriers (electrons and holes) for generating light, and may induce efficient generation of excitons. The dopant may include a phosphorescent dopant or a fluorescent dopant. According to embodiments, examples of the dopant are not particularly limited. According to embodiments, the dopant may include an organic material, and may also include a metal complex, and the like.

The light-emitting layer EML may include a first light-emitting layer EML1 disposed in the first sub-pixel area SPXA1 and forming the first sub-pixel SPX1, a second light-emitting layer EML2 disposed in the second sub-pixel area SPXA2 and forming the second sub-pixel SPX2, and a third light-emitting layer EML3 disposed in the third sub-pixel area SPXA3 and forming the third sub-pixel SPX3.

The electron transport unit ETU may include a multilayer structure having a plurality of layers each including different materials. The electron transport unit ETU may include an electron injection layer and an electron transport layer, and according to embodiments, may further include an electron buffer layer, a hole blocking layer, and the like.

The electron transport unit ETU may include a first electron transport unit ETU1 disposed in the first sub-pixel area SPXA1 and forming the first sub-pixel SPX1, a second electron transport unit ETU2 disposed in the second sub-pixel area SPXA2 and forming the second sub-pixel SPX2, and a third electron transport unit ETU3 disposed in the third sub-pixel area SPXA3 and forming the third sub-pixel SPX3.

According to embodiments, the light-emitting part EL may be formed based on the inkjet printing process. For example, ink INK including a material forming the light-emitting part EL may be supplied in the area surrounded by the second pixel definition layer PDL2.

The cathode electrode CE may be disposed on the light-emitting part EL, the first pixel definition layer PDL1, and the second pixel definition layer PDL2. The cathode electrode CE may be disposed across the first to third sub-pixel areas SPXA1 to SPXA3. The cathode electrode CE may be a common electrode for the first to third sub-pixels SPX1 to SPX3. The cathode electrode CE may include various conductive materials. For example, the cathode electrode CE may include a transparent conductive material. However, embodiments of the present disclosure are not limited thereto.

According to embodiments, the anode electrode AE, the light-emitting part EL, and the cathode electrode CE may form the light-emitting element LD.

The first cathode connection line CCE1 may be disposed on the pixel circuit layer PCL in the non-display area NDA. The first cathode connection line CCE1 may be patterned in a same process as the anode electrode AE and may include a same conductive material.

The first cathode connection line CCE1 may be disposed on the outside of the dummy dam DUM. For example, the display area DA may be formed on one side of the dummy dam DUM, and the first cathode connection line CCE1 may be disposed on the other side of the dummy dam DUM.

The first cathode connection line CCE1 may be electrically connected to a cathode power line (not illustrated) that supplies a cathode power voltage. Accordingly, the cathode power voltage may be suitably applied to the first cathode connection line CCE1.

The first pixel definition layer PDL1 may be disposed on the pixel circuit layer PCL. The first pixel definition layer PDL1 may cover a portion of the anode electrode AE and expose another portion of the anode electrode AE.

According to embodiments, a cross-section of the first pixel definition layer PDL1 may have a normal-tapered shape. For example, a side surface of the first pixel definition layer PDL1 may have an angle of less than 90 degrees with respect to the plane on which the base layer BSL is disposed.

The second pixel definition layer PDL2 may be disposed on the pixel circuit layer PCL. The second pixel definition layer PDL2 may cover a portion of the anode electrode AE and expose another portion of the anode electrode AE.

According to embodiments, the first pixel definition layer PDL1 and the second pixel definition layer PDL2 may overlap in some areas in a plan view.

According to embodiments, a cross-section of the second pixel definition layer PDL2 may have a reverse-tapered shape. For example, a side surface of the second pixel definition layer PDL2 may have an angle greater than 90 degrees with respect to the plane on which the base layer BSL is disposed.

Descriptions herein of an element having a cross-section of a normal-tapered shape may refer to a cross-section of the element having a normal-tapered shape. Descriptions herein of an element having a cross-section of a reverse-tapered shape may refer to a cross-section of the element having a reverse-tapered shape.

As described herein, the light-emitting part EL may be formed based on the inkjet printing process. According to an embodiment, ink INK including a material forming the light-emitting part EL may be supplied to an area surrounded by the second pixel definition layer PDL2. Since a cross-section of the second pixel definition layer PDL2 has a reverse-tapered shape, ink INK may be more efficiently accommodated in the area surrounded by the second pixel definition layer PDL2.

The dummy dam DUM may be disposed on the pixel circuit layer PCL. The dummy dam DUM may cover a portion of the first cathode connection line CCE1 and expose another portion of the first cathode connection line CCE1.

According to embodiments, a cross-section of the dummy dam DUM may have a normal-tapered shape. For example, a side surface of the dummy dam DUM may have an angle of less than 90 degrees with respect to the plane on which the base layer BSL is disposed.

The second cathode connection line CCE2 may be disposed on the pixel circuit layer PCL and may cover the dummy dam DUM and the first cathode connection line CCE1. The second cathode connection line CCE2 may be patterned in a same process as the cathode electrode CE and may include a same conductive material.

According to embodiments, the second cathode connection line CCE2 may entirely cover the upper surface and side surfaces of the dummy dam DUM.

A portion of the second cathode connection line CCE2 may be electrically connected to the first cathode connection line CCE1. Accordingly, the second cathode connection line CCE2 may receive the cathode power voltage.

According to embodiments, since a cross-section of the dummy dam DUM has a normal-tapered shape, the second cathode connection line CCE2 disposed on the dummy dam DUM may not be disconnected, and the second cathode connection line CCE2 may continuously form a cathode signal path.

Another portion of the second cathode connection line CCE2 may be electrically connected to the cathode electrode CE. For example, the second cathode connection line CCE2 may be formed integrally with the cathode electrode CE. Accordingly, the cathode power voltage supplied to the first cathode connection line CCE1 may be applied to the cathode electrode CE through the second cathode connection line CCE2. Accordingly, the cathode signal may be normally supplied to the light-emitting element LD, and light may be suitably provided.

According to embodiments, since a cross-section of the first pixel definition layer PDL1 has a normal-tapered shape, the cathode electrode CE disposed on the first pixel definition layer PDL1 may not be disconnected, and the cathode electrode CE may continuously form the cathode signal path.

As a result, according to an embodiment, due to the cross-sectional shapes of the dummy dam DUM and the first pixel definition layer PDL1, the cathode signal path to which the cathode power voltage may be supplied may be clearly formed, and the operation reliability of the light-emitting element LD may be improved.

In some embodiments, according to embodiments, the light-emitting element layer LEL may further include an encapsulation layer (not illustrated). For example, the encapsulation layer may be disposed on the light-emitting element LD (e.g., the cathode electrode CE). The encapsulation layer may include a plurality of insulating layers covering the light-emitting element LD. According to embodiments, the encapsulation layer may include an inorganic layer and an organic layer. For example, the encapsulation layer may have a structure in which a first inorganic layer/organic layer/second inorganic layer are sequentially disposed. However, embodiments of the present disclosure are not limited thereto. According to embodiments, the encapsulation layer may be a thin film encapsulation film.

Next, a display device DD according to the second embodiment will be described with reference to FIGS. 3, 7, and 8. Contents that may overlap with descriptions of other display devices DD described herein will be briefly described or not repeated.

Referring to FIGS. 3, 7, and 8, the display device DD according to the second embodiment is different from the display device DD according to the first embodiment in that the display device DD according to the second embodiment further includes a connecting pattern layer COP.

According to embodiments, a cross-section of the dummy dam DUM may have a reverse-tapered shape. For example, a side surface of the dummy dam DUM may have an angle exceeding 90 degrees with respect to the plane on which the base layer BSL is disposed.

According to embodiments, the display device DD may further include a connecting pattern layer COP.

The connecting pattern layer COP may be disposed on the dummy dam DUM for which a cross-section has a reverse-tapered shape. The connecting pattern layer COP may cover the upper surface and side surfaces of the dummy dam DUM. For example, the connecting pattern layer COP may cover both a first side surface and a second side surface of the dummy dam DUM.

According to embodiments, the connecting pattern layer COP may include various organic materials. However, the present disclosure is not limited to a specific example.

A cross-section of the connecting pattern layer COP may have a normal-tapered shape. For example, a side surface of the connecting pattern layer COP may have an angle of less than 90 degrees with respect to the plane on which the base layer BSL is disposed.

According to embodiments, the second cathode connection line CCE2 may be disposed on the connecting pattern layer COP and may cover the upper surface and side surfaces of the connecting pattern layer COP.

According to embodiments, a cross-section of the dummy dam DUM has a cross-section of a reverse-tapered shape, but a cross-section of the connecting pattern layer COP has a normal-tapered shape, such that the second cathode connection line CCE2 disposed on the dummy dam DUM and the connecting pattern layer COP may not be disconnected, and the second cathode connection line CCE2 may continuously form the cathode signal path.

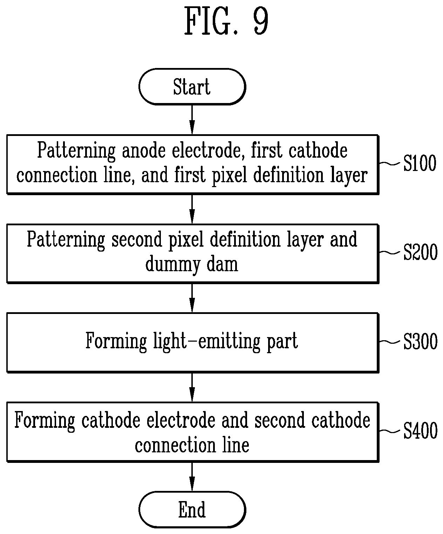

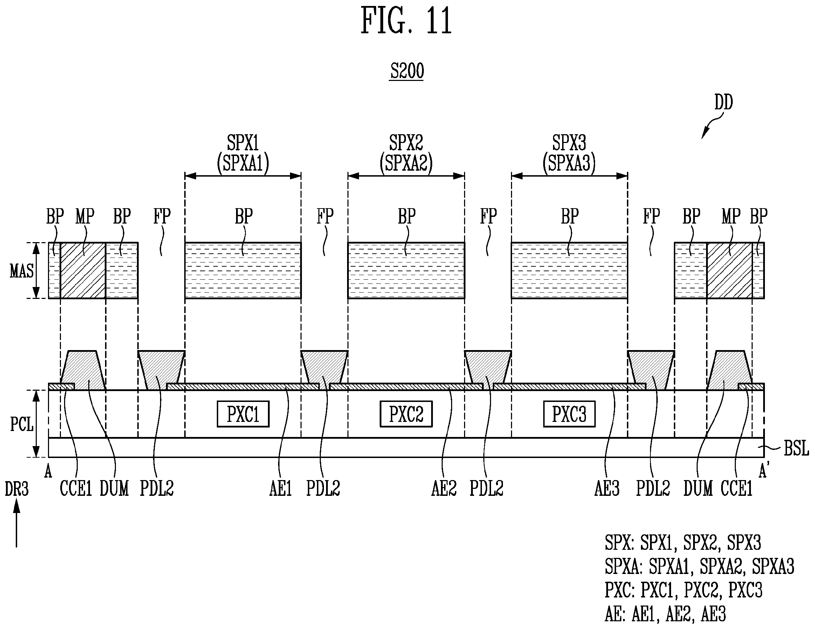

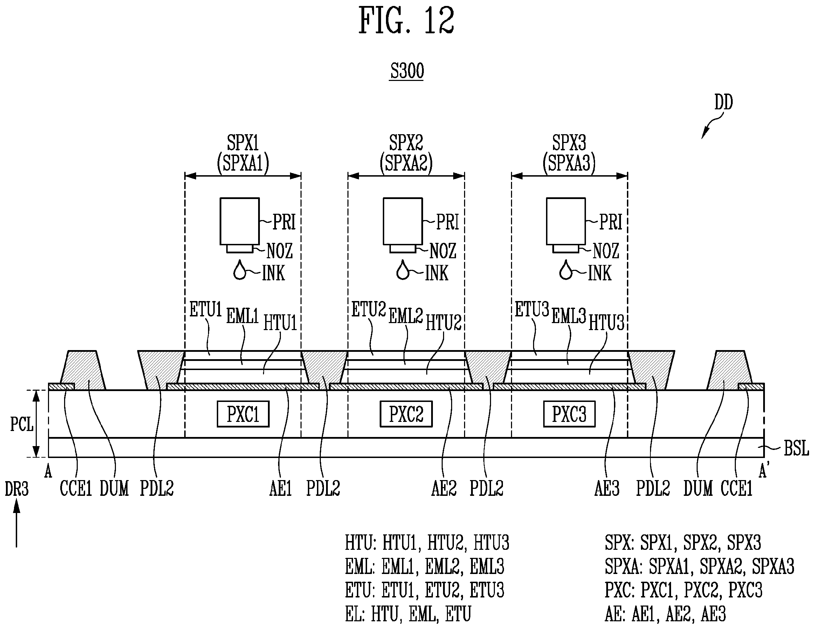

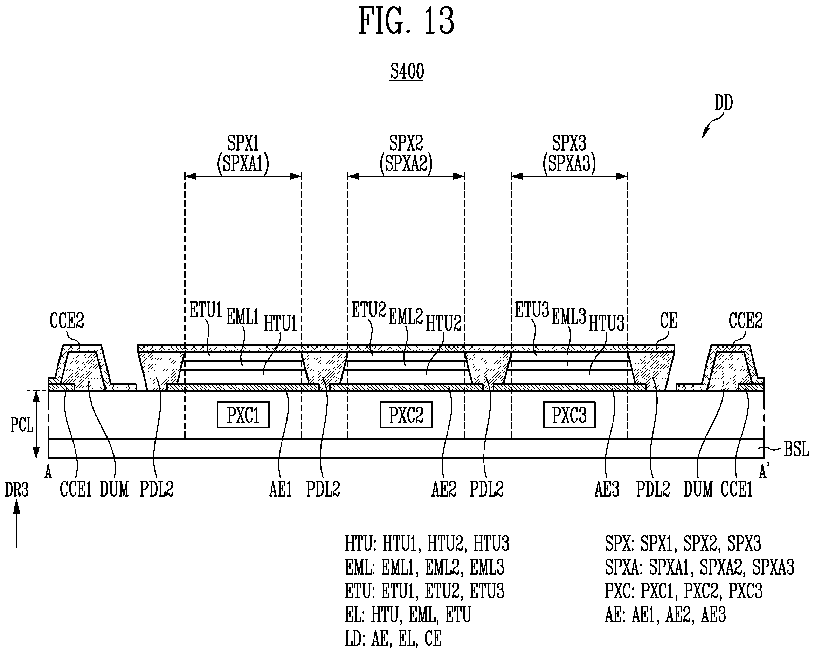

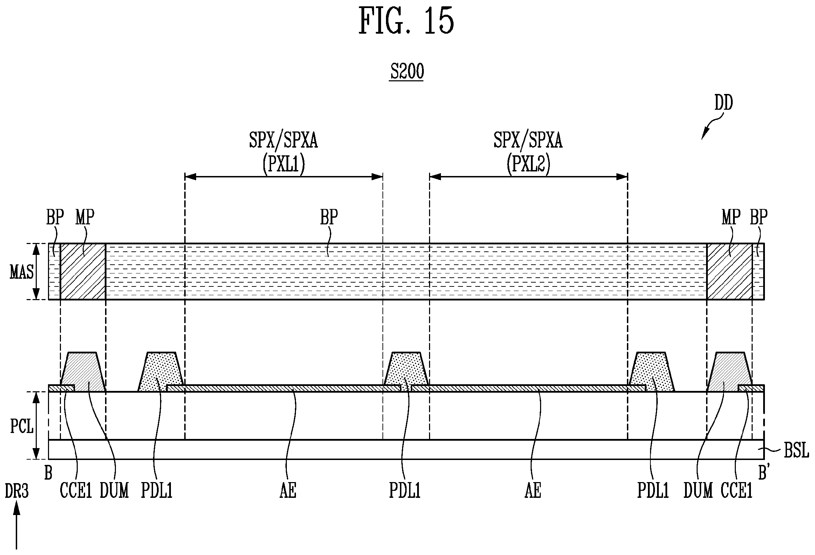

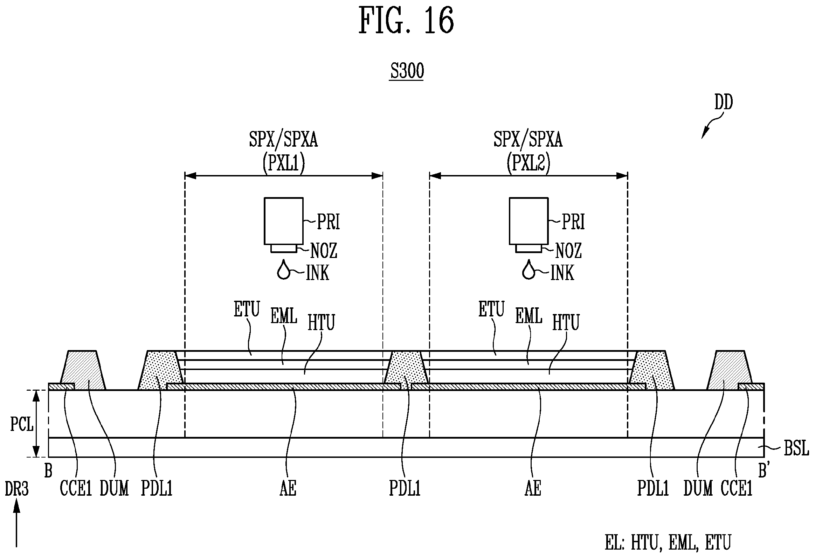

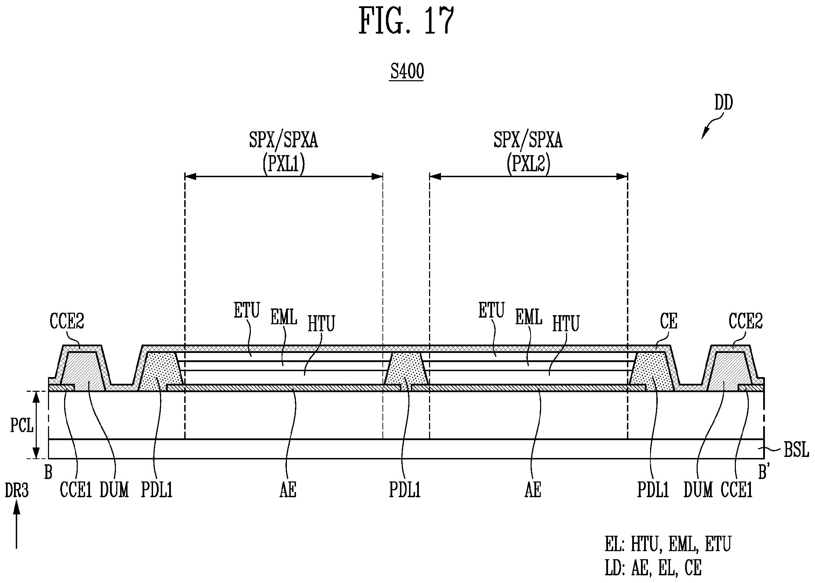

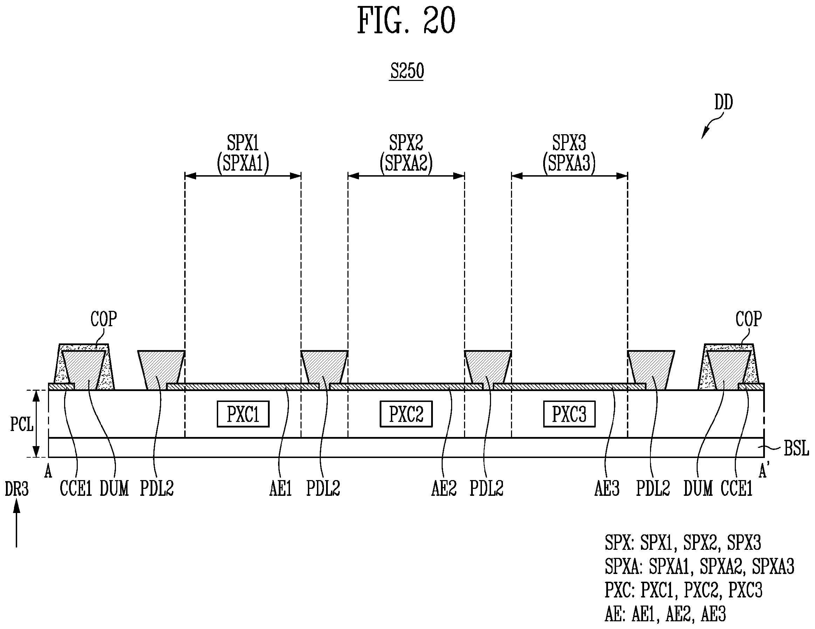

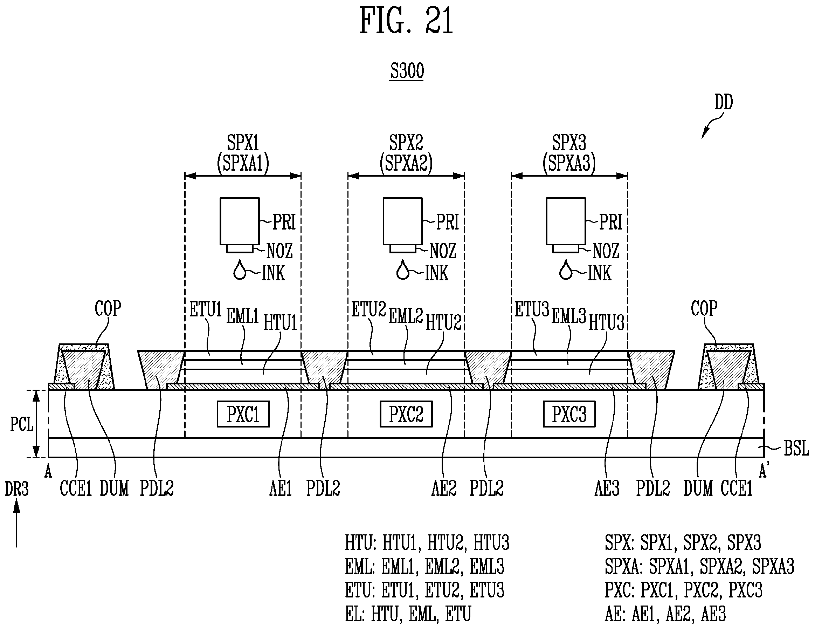

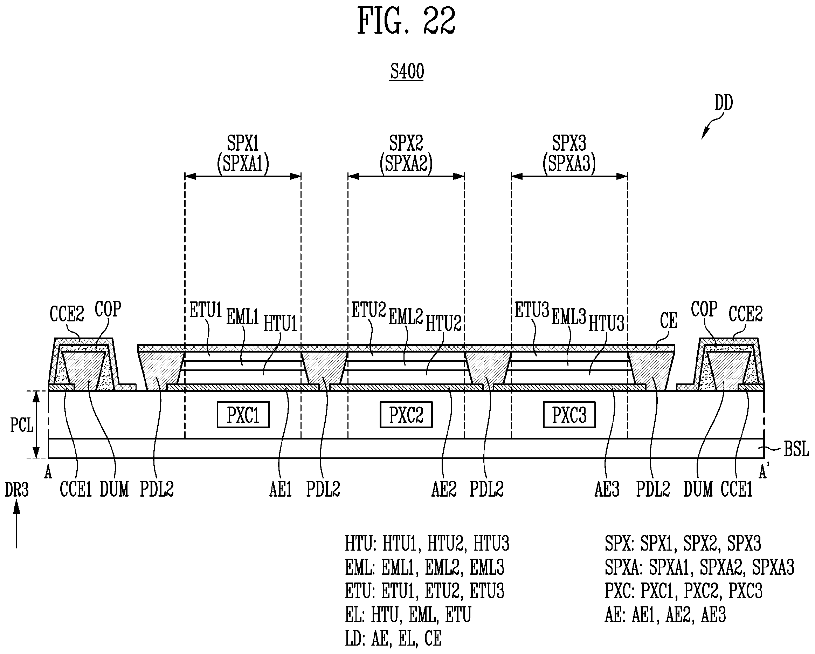

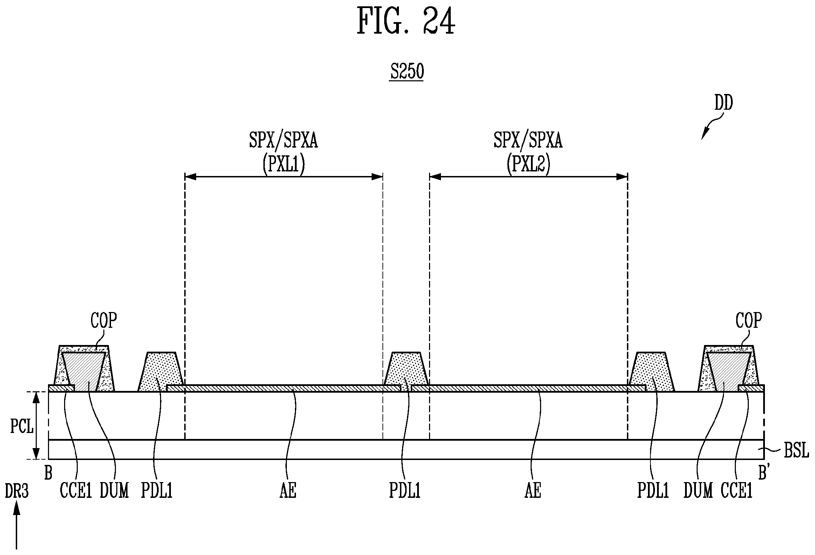

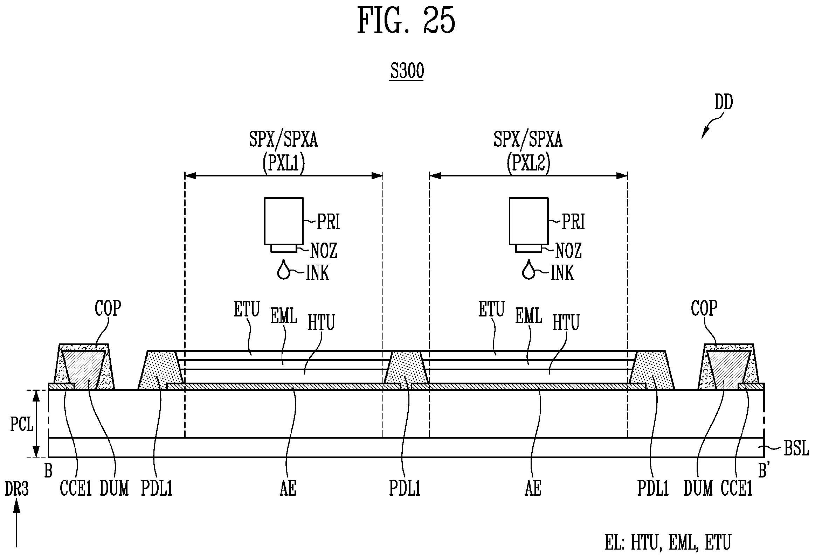

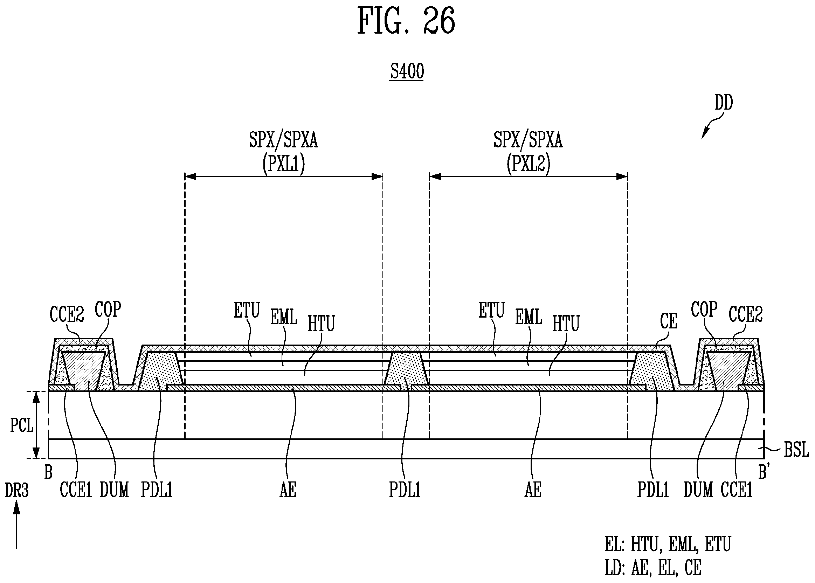

Referring to FIGS. 9 to 26, a method of manufacturing a display device DD according to an embodiment will be described. Contents that may overlap with descriptions of other display devices DD or methods described herein will be briefly described or not repeated.

In the descriptions of the methods and processes herein, the operations may be performed in a different order than the order shown and/or described, or the operations may be performed in different orders or at different times. Certain operations may also be left out of the flowcharts, one or more operations may be repeated, or other operations may be added. Descriptions that an element "may be disposed," "may be formed," and the like include methods, processes, and techniques for disposing, forming, positioning, and modifying the element, and the like in accordance with example aspects described herein.

First, referring to FIGS. 9 to 17, a method of manufacturing the display device DD according to the first embodiment will be described.

FIG. 9 is a flowchart illustrating a method of manufacturing the display device according to the first embodiment.

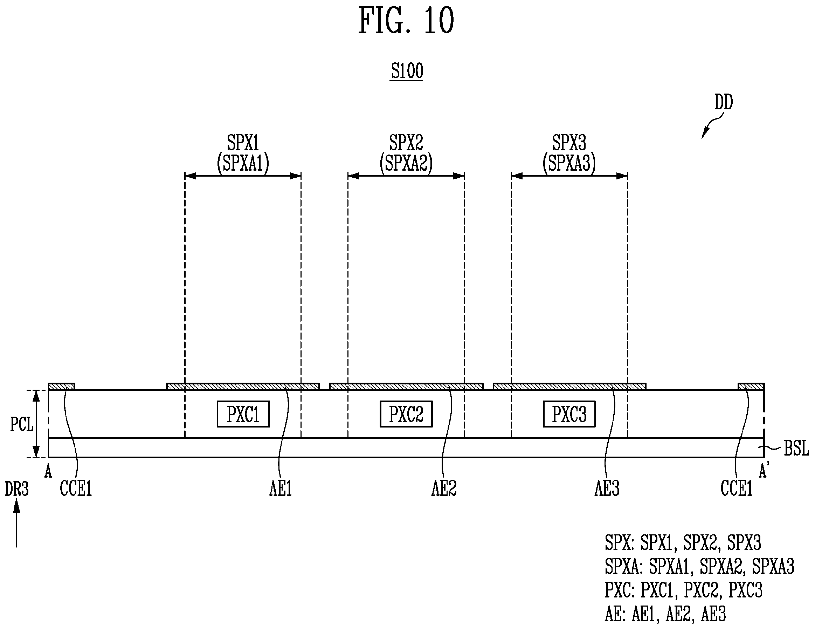

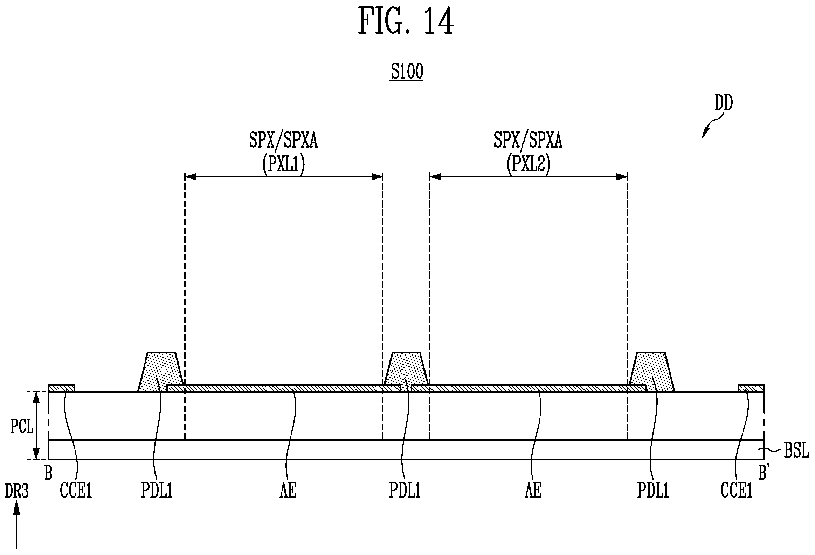

FIGS. 10 to 17 are schematic cross-sectional views for respective process steps illustrating a method of manufacturing the display device according to the first embodiment. For convenience of explanation, FIGS. 10 to 13 are illustrated based on the cross-sectional structure described herein with reference to FIG. 5. For convenience of explanation, FIGS. 14 to 17 are illustrated based on the cross-sectional structure described herein with reference to FIG. 6.

Referring to FIG. 9, a method of manufacturing a display device DD according to an embodiment may include patterning an anode electrode, a first cathode connection line, and a first pixel definition layer (S100), patterning a second pixel definition layer and a dummy dam (S200), forming a light-emitting part (S300), and forming a cathode electrode and a second cathode connection line (S400).

Referring to FIGS. 9, 10, and 14, in the patterning of the anode electrode, the first cathode connection line, and the first pixel definition layer (S100), the method may include providing a pixel circuit layer PCL, and further, disposing the anode electrode AE, the first cathode connection line CCE1, and the first pixel definition layer PDL1 on the pixel circuit layer PCL.

In this step (S100), the method may include patterning first to third pixel circuits PXC1 to PXC3 on a base layer BSL.

According to embodiments, the method may include forming a conductive layer or an insulating layer on the base layer BSL based on a conventional process for manufacturing a semiconductor device. For example, the method may include forming the conductive layer or the insulating layer on the base layer BSL by a photolithography process, etching the conductive layer or the insulating layer by various methods (wet etching, dry etching, and the like), and depositing the conductive layer or the insulating layer by various methods (sputtering, chemical vapor deposition, and the like). The present disclosure is not necessarily limited to a particular example.

In this step (S100), the method may include patterning the anode electrode AE and the first cathode connection line CCE1 in a same process.

In this step (S100), after patterning the anode electrode AE and the first cathode connection line CCE1, the method may include patterning the first pixel definition layer PDL1 covering the anode electrode AE. Referring to FIG. 3, the first pixel definition layer PDL1 may be patterned such that the first pixel definition layer PDL1 extends along the first direction DR1.

Referring to FIG. 9, FIG. 11, and FIG. 15, in the patterning of the second pixel definition layer and the dummy dam (S200), the method may include patterning the second pixel definition layer PDL2 and the dummy dam DUM using a photomask MAS.

In this step (S200), the method may include forming (e.g., depositing) an organic insulating layer associated with forming the second pixel definition layer PDL2 and the dummy dam DUM, and further, forming a photoresist layer on the organic insulating layer. The method may include patterning (e.g., exposing) the photoresist layer using the photomask MAS to manufacture an etching mask, and further, patterning the organic insulating layer using the manufactured etching mask, thereby providing the second pixel definition layer PDL2 and the dummy dam DUM according to an embodiment.

According to embodiments, the photoresist layer may include a negative type photoresist. However, the present disclosure is not necessarily limited thereto. For convenience of explanation, the following description will be based on an embodiment in which the photoresist layer includes a negative type photoresist.

According to embodiments, the photomask MAS may include a full tone part FP, a middle part MP, and a blocking part BP. The full tone part FP may transmit light during the exposure process. The middle part MP may partially transmit some of the light and/or light during the exposure process. The blocking part BP may block light during the exposure process. According to embodiments, the middle part MP may be a slit part or a half tone part.

In this step (S200), the position of the full tone part FP may correspond to the position of the second pixel definition layer PDL2. The position of the full tone part FP may overlap the second pixel definition layer PDL2 in a plan view. According to embodiments, since a negative type photoresist is used, the photoresist may remain at the position of the full tone part FP, and the second pixel definition layer PDL2 for which a cross-section has a reverse-tapered shape may be provided.

In this step (S200), the position of the middle part MP may correspond to the position of the dummy dam DUM. The position of the middle part MP may overlap with the dummy dam DUM in a plan view. According to embodiments, since a negative type photoresist is used, the photoresist may partially remain or be formed thinly (e.g., having a thickness less than a threshold value) at the position of the middle part MP, and after the etching process is performed, the method may include reflowing materials forming the dummy dam DUM such that the materials provide the dummy dam DUM for which a cross-section has a normal-tapered shape.

In this step (S200), the position of the blocking part BP may correspond to an area where the second pixel definition layer PDL2 and the dummy dam DUM are not disposed. The position of the blocking part BP may overlap with the area where the second pixel definition layer PDL2 and the dummy dam DUM are not disposed in a plan view. According to embodiments, since a negative type photoresist is used, the photoresist may be removed at the position of the blocking part BP, and the second pixel definition layer PDL2 and the dummy dam DUM may not be formed at a position corresponding to the blocking part BP.

In this step (S200), when combining aspects of FIG. 3, the method may include patterning the second pixel definition layer PDL2 such that the second pixel definition layer PDL2 extends along the second direction DR2.

Referring to FIGS. 9, 12, and 16, in the forming of the light-emitting part (S300), the method may include forming the light-emitting part EL based on an inkjet printing process.

In this step (S300), the method may include sequentially ejecting (i.e., discharging), via the nozzle part NOZ of the printing device PRI, inks INK including materials of each layer supportive of forming the light-emitting part EL and a solvent (for example, an organic solvent). The ink INK may be provided to the area surrounded by the second pixel definition layer PDL2. Thereafter, for example, the method may include performing a drying process which may remove the solvent included in the ink INK.

In this step (S300), when combining aspects of FIGS. 3 and 4, the ink INK may be supplied between the second pixel definition layers PDL2 disposed across the first and second pixels PXL1 and PXL2 that are adjacent to each other. For example, ink INK may be supplied between second pixel definition layers PDL2 adjacent in the first direction DR1. The term "adjacent" herein may refer to elements which are relatively close to each other (e.g., within a threshold distance) or elements which are in contact with each other.

As described herein, since a cross-section of the second pixel definition layer PDL2 has a reverse-tapered shape, ink INK may be suitably accommodated in the area surrounded by the second pixel definition layer PDL2.

Referring to FIGS. 9, 13, and 17, in the forming of the cathode electrode and the second cathode connection line (S400), the method may include entirely depositing a conductive layer supportive of forming the cathode electrode CE and the second cathode connection line CCE2.

In this step (S400), the method may include patterning the cathode electrode CE and the second cathode connection line CCE2 in a same process and forming the cathode electrode CE and the second cathode connection line CCE2 integrally with each other.

In this step (S400), the deposited conductive layer may form the cathode electrode CE covering the upper surface of the second pixel definition layer PDL2 and the light-emitting parts EL. The deposited conductive layer may form the second cathode connection line CCE2 covering the dummy dam DUM and the first cathode connection line CCE1. At this time, the second cathode connection line CCE2 may cover the dummy dam DUM entirely.

In this step (S400), the method may include disposing the second cathode connection line CCE2 such that the second cathode connection line CCE2 is directly adjacent to the dummy dam DUM. The method may include disposing the cathode electrode CE such that the cathode electrode CE is directly adjacent to the first pixel definition layer PDL1.

As described herein, since respective cross-sections of the first pixel definition layer PDL1 and the dummy dam DUM each have a normal-tapered shape, the cathode electrode CE and the second cathode connection line CCE2 may suitably form the cathode signal path without being disconnected.

Subsequently, according to embodiments, the method may further include forming an encapsulation layer and disposing an upper layer UL in association with providing the display device DD according to an embodiment.

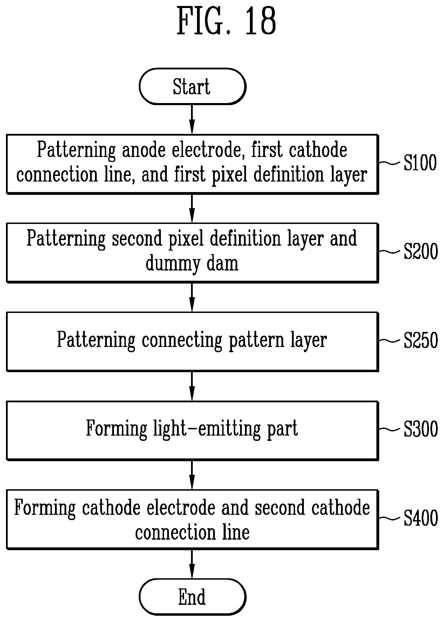

Next, referring to FIGS. 18 to 26, a method of manufacturing the display device DD according to the second embodiment will be described. Contents that may overlap with descriptions of other display devices DD or methods described herein will be briefly described or not repeated.

FIG. 18 is a flowchart illustrating a method of manufacturing the display device according to the second embodiment.

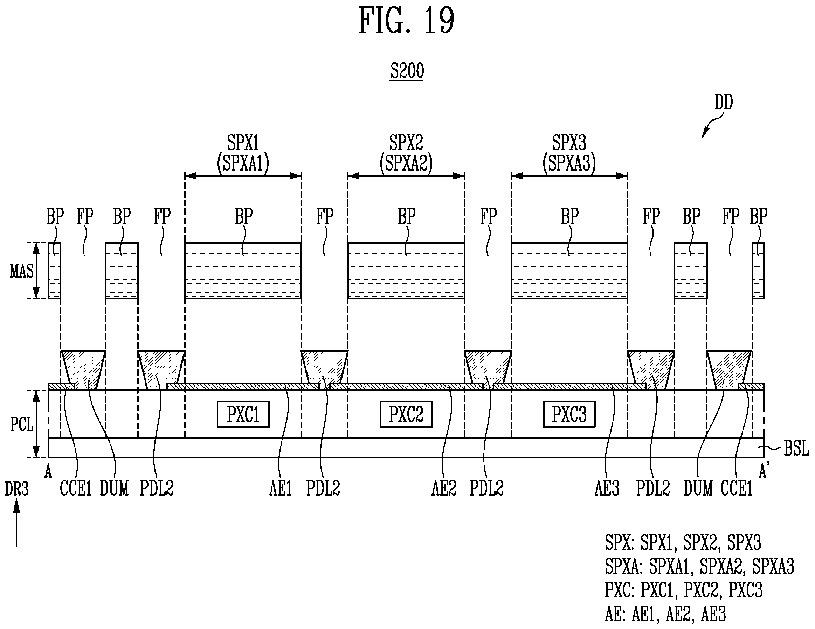

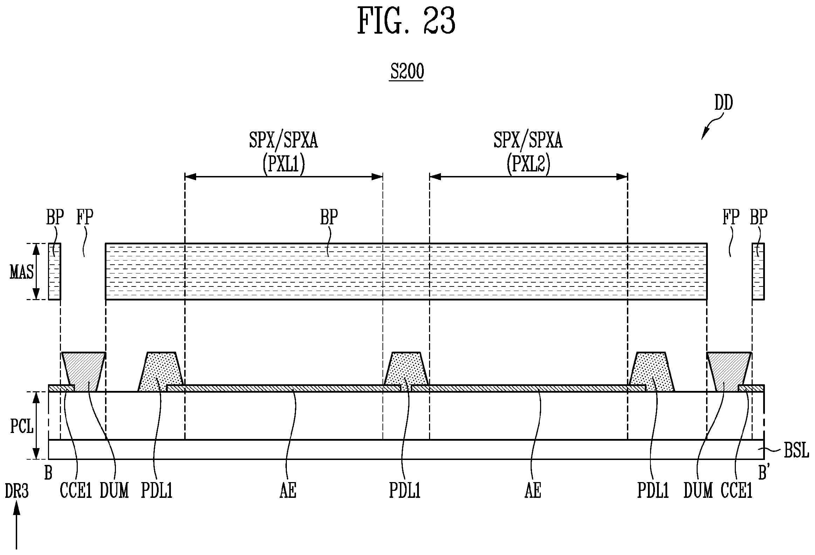

FIGS. 19 to 26 are schematic cross-sectional views for respective process steps illustrating a method of manufacturing the display device according to the second embodiment. For convenience of explanation, FIGS. 19 to 22 are illustrated based on the cross-sectional structure described herein with reference to FIG. 7. For convenience of explanation, FIGS. 23 to 26 are illustrated based on the cross-sectional structure described herein with reference to FIG. 8.

Referring to FIG. 18, a method of manufacturing a display device DD according to an embodiment may include patterning an anode electrode, a first cathode connection line, and a first pixel definition layer (S100), patterning a second pixel definition layer and a dummy dam (S200), forming a light-emitting part (S300), and forming a cathode electrode and a second cathode connection line (S400), and may further include patterning a connecting pattern layer (S250).

The method of manufacturing the display device DD according to the present embodiment may include performing the patterning of the anode electrode, the first cathode connection line, and the first pixel definition layer (S100) described herein substantially identically.

Referring to FIGS. 18, 19, and 23, in the patterning of the second pixel definition layer and the dummy dam (S200), the method may include patterning the second pixel definition layer PDL2 and the dummy dam DUM using the photomask MAS.

In this step (S200), the method may include patterning the dummy dam DUM in the area corresponding to the position of the full tone part FP. For example, the position of the full tone part FP may correspond to the position of the dummy dam DUM. The position of the full tone part FP may overlap with the dummy dam DUM when viewed in a plane. According to embodiments, since a negative type photoresist is used, the photoresist may remain at the position of the full tone part FP, and the dummy dam DUM for which a cross-section has a reverse-tapered shape may be provided.

In this step (S200), the second pixel definition layer PDL2 for which a cross-section has a reverse-tapered shape may be provided.

Referring to FIGS. 18, 20, and 24, in the patterning of the connecting pattern layer (S250), the method may include disposing the connecting pattern layer COP covering the dummy dam DUM.

In this step (S250), the method may include patterning the connecting pattern layer COP having a cross-section having a normal-tapered shape. The method may include patterning the connecting pattern layer COP such that the connecting pattern layer COP covers the upper surface and side surfaces of the dummy dam DUM.

Referring to FIGS. 18, 21, and 25, in the forming of the light-emitting part (S300), the method may include forming the light-emitting part EL based on the inkjet printing process.

In the method of manufacturing the display device DD according to the present embodiment, the forming of the light-emitting part (S300) described herein may be performed substantially in a same manner as other examples described herein of manufacturing the display device DD.

Referring to FIGS. 18, 22, and 26, in the forming of the cathode electrode and the second cathode connection line (S400), the method may include fully depositing a conductive layer supportive of forming the cathode electrode CE and the second cathode connection line CCE2.

In this step (S400), the method may include patterning the cathode electrode CE and the second cathode connection line CCE2 in a same process.

In this step (S400), the deposited conductive layer may form the cathode electrode CE covering the upper surface and the light-emitting parts EL of the second pixel definition layer PDL2, and the deposited conductive layer may form the second cathode connection line CCE2 covering the dummy dam DUM, the connecting pattern layer COP, and the first cathode connection line CCE1.

As described herein, since respective cross-sections of the connecting pattern layer COP covering the dummy dam DUM and the first pixel definition layer PDL1 each have a normal-tapered shape, the cathode electrode CE and the second cathode connection line CCE2 may suitably form the cathode signal path without being disconnected.

Subsequently, according to embodiments, the method may further include forming an encapsulation layer and disposing an upper layer UL in association with providing the display device DD according to an embodiment.

Hereinafter, an electronic device 1000 including the display device DD in accordance with an embodiment will be described.

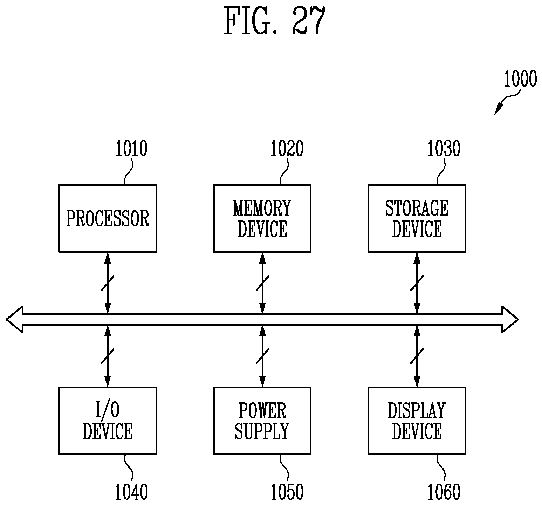

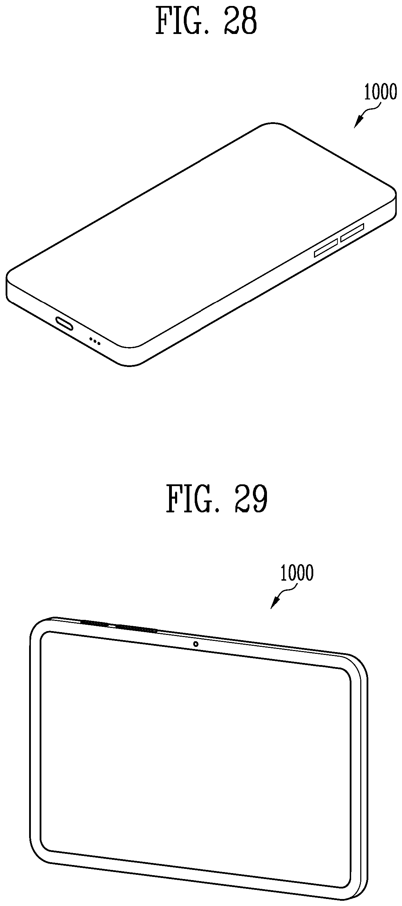

FIG. 27 is a schematic block diagram illustrating an electronic device 1000 including a display device in accordance with an embodiment. FIG. 28 is a schematic diagram illustrating an example where the electronic device 1000 of FIG. 27 is implemented as a smartphone. FIG. 29 is a schematic diagram illustrating an example where the electronic device 1000 of FIG. 27 is implemented as a tablet computer.

Referring to FIGS. 27 to 29, the electronic device 1000 may include a processor 1010, a memory device 1020, a storage device 1030, an input/output (I/O) device 1040, a power supply 1050, and a display device 1060. The display device 1060 may be the display device DD of FIG. 1. The electronic device 1000 may further include various ports for communication with a video card, a sound card, a memory card, a USB device, or other systems. In an embodiment, as illustrated in FIG. 28, the electronic device 1000 may be implemented as a smartphone. In an embodiment, as illustrated in FIG. 29, the electronic device 1000 may be implemented as a tablet computer. However, the aforementioned examples are illustrative, and the electronic device 1000 is not necessarily limited to the aforementioned examples. For example, the electronic device 1000 may be implemented as a cellular phone, a video phone, a smartpad, a smartwatch, a navigation device for vehicles, a computer monitor, a laptop computer, a head-mounted display device, or the like.

The processor 1010 may perform specific calculations or tasks. In an embodiment, the processor 1010 may be a micro-processor, a central processing unit, an application processor, or the like. The processor 1010 may be connected to other components through an address bus, a control bus, a data bus, and the like. In an embodiment, the processor 1010 may be connected to an expansion bus such as a peripheral component interconnect (PCI) bus. In an embodiment, the processor 1010 may provide input image data to the display device 1060. Hence, the display device 1060 may display an image based on the input image data provided from the processor 1010.

The memory device 1020 may store data needed to perform the operation of the electronic device 1000. The memory device 1020 may function as a working memory and/or a buffer memory for the processor 1010. For example, the memory device 1020 may include one or more volatile memory devices such as a dynamic random access memory (DRAM) device, a static random access memory (SRAM) device, and a mobile DRAM device.

The storage device 1030 may store data in response to control signals or data from the processor 1010. The storage device 1030 may include one or more non-volatile storages to retain the data even when the electronic device 1000 is powered off. In some embodiments, the storage device 1030 may include a solid state drive (SSD), a hard disk drive (HDD), a CD-ROM, or the like.

The I/O device 1040 may include input devices such as a keyboard, a keypad, a touchpad, a touch screen, and a mouse, and output devices such as a speaker and a printer. In an embodiment, the display device 1060 may be included in the I/O device 1040.

The power supply 1050 may supply power needed to perform the operation of the electronic device 1000. For example, the power supply 1050 may be a power management integrated circuit (PMIC). In an embodiment, the power supply 1050 may supply power to the display device 1060.

The display device 1060 may display an image corresponding to visual information of the electronic device 1000. The display device 1060 may be connected to other components through the buses or other communication links.

Although the present disclosure has been described with reference to example embodiments as discussed above, those skilled in the art or those with ordinary knowledge in the art will be able to understand that the present disclosure may be modified and changed in various ways in the scope of the ideas and techniques of the present disclosure described in the appended claims.

Therefore, the technical scope of the present disclosure should not be limited to what is described in the detailed description of the specification, but should be determined by the scope of the claims.

## Claims

1. A display device (1060, DD) comprising a display area (DA) and a non-display area (NDA), the display device (1060, DD) comprising:
a base layer (BSL) which is disposed across the display area (DA) and the non-display area (NDA);
a light-emitting element (LD) which is disposed on the base layer (BSL) in the display area (DA) and comprises an anode electrode (AE), a cathode electrode (CE), and a light-emitting part (EL) electrically connected between the anode electrode (AE) and the cathode electrode (CE);
a first pixel definition layer (PDL1) and a second pixel definition layer (PDL2) which are disposed on the base layer (BSL) in the display area (DA); and
a dummy dam (DUM) which is disposed on the base layer (BSL) in the non-display area (NDA) and surrounds at least a portion of the display area (DA),
wherein:
the first pixel definition layer (PDL1) extends in a first direction (DR1), and the second pixel definition layer (PDL2) extends in a second direction (DR2) different from the first direction (DR1),
the light-emitting part (EL) is disposed in an area surrounded by the first pixel definition layer (PDL1) and the second pixel definition layer (PDL2),
a cross-section of the second pixel definition layer (PDL2) has a reverse-tapered shape, and
a cross-section of the dummy dam (DUM) has a normal-tapered shape.

2. The display device (1060, DD) according to claim 1, wherein the display device (1060, DD) comprises:
a first pixel and a second pixel which are adjacent to each other along the second direction (DR2), wherein each of the first pixel and the second pixel comprises the light-emitting element (LD),
wherein:
each of the first pixel and the second pixel comprises a first sub-pixel area (SPXA1) in which light of a first color is provided, a second sub-pixel area (SPXA2) in which light of a second color is provided, and a third sub-pixel area (SPXA3) in which light of a third color is provided,
the first sub-pixel area (SPXA1), the second sub-pixel area (SPXA2), and the third sub-pixel area (SPXA3) are adjacent to the second pixel definition layer (PDL2) in the first direction (DR1),
the first sub-pixel area (SPXA1) of the first pixel and the first sub-pixel area of the second pixel are adjacent to each other in the second direction (DR2),
the second sub-pixel area (SPXA2) of the first pixel and the second sub-pixel area (SPXA2) of the second pixel are adjacent to each other in the second direction (DR2), and
the third sub-pixel area (SPXA3) of the first pixel and the third sub-pixel area (SPXA3) of the second pixel are adjacent to each other in the second direction (DR2).

3. The display device (1060, DD) according to claim 1 or 2, wherein:
the dummy dam (DUM) entirely surrounds the display area (DA),
the dummy dam (DUM) and the second pixel definition layer (PDL2) comprise a same material, and
the dummy dam (DUM), the first pixel definition layer (PDL1), and the second pixel definition layer (PDL2) comprise an organic material.

4. The display device (1060, DD) according to claims 1 to 3, further comprising:
a first cathode connection line (CCE1) which is disposed in the non-display area (NDA) and comprises a same material as the anode electrode (AE); and
a second cathode connection line (CCE2) which comprises a same material as the cathode electrode (CE), covers the dummy dam (DUM), and is electrically connected to the first cathode connection line,
wherein:
the cathode electrode (CE) and the second cathode connection line (CCE2) are integral with each other,
the display area (DA) is formed on one side of the dummy dam (DUM), and
the first cathode connection line (CCE1) is formed on another side of the dummy dam.

5. The display device (1060, DD) according to claims 1 to 4, wherein a cross-section of the first pixel definition layer (PDL1) has a normal-tapered shape.

6. The display device (1060, DD) according to claims 1 to 5, wherein the first pixel definition layer (PDL1) and the second pixel definition layer (PDL2) form an opening (OPN) and have liquid repellency, wherein the light-emitting part (EL) is suitably provided in the opening (OPN) using the inkjet printing process.

7. The display device (1060, DD) according to claims 1 to 6, wherein the display device (1060, DD) comprises a pixel circuit layer (PCL) and a light-emitting element layer (LEL), wherein the light-emitting element layer (LEL) further comprises an encapsulation layer.

8. A display device (1060, DD) comprising a display area (DA)and a non-display area (NDA), the display device (1060, DD) comprising:
a base layer (BSL) which is disposed across the display area (DA) and the non-display area (NDA);
a light-emitting element (LD) which is disposed on the base layer (BSL) in the display area (DA) and comprises an anode electrode (AE), a cathode electrode (CE), and a light-emitting part (EL) electrically connected between the anode electrode (AE) and the cathode electrode (CE);
a first pixel definition layer (PDL1) and a second pixel definition layer (PDL2) which are disposed on the base layer (BSL) in the display area;
a dummy dam (DUM) which is disposed on the base layer (BSL) in the non-display area (NDA) and surrounds at least a portion of the display area (DA); and
a connecting pattern layer (COP) which covers a side surface and an upper surface of the dummy dam (DUM),
wherein:
the first pixel definition layer (PDL1) extends in a first direction (DR1), and the second pixel definition layer (PDL2) extends in a second direction (DR2) different from the first direction (DR1),
the light-emitting part (EL) is disposed in an area surrounded by the first pixel definition layer (PDL1) and the second pixel definition layer (PDL2),
a cross-section of the first pixel definition layer (PDL1) has a normal-tapered shape,
a cross-section of the second pixel definition layer (PDL2) has a reverse-tapered shape,
a cross-section of the dummy dam (DUM) has a reverse-tapered shape, and
a cross-section of the connecting pattern layer (COP) has a normal-tapered shape.

9. A method of manufacturing a display device (1060, DD), the method comprising:
patterning an anode electrode (AE), a first cathode connection line (CCE1), and a first pixel definition layer (PDL1) extending in a first direction (DR1) on a base layer (BSL);
patterning a second pixel definition layer (PDL2) extending in a second direction (DR2) different from the first direction (DR1) and a dummy dam (DUM);
forming a light-emitting part (EL) in an area surrounded by the second pixel definition layer (PDL2) using an inkjet process; and
forming a cathode electrode (CE) and a second cathode connection line (CCE2),
wherein the forming of the cathode electrode (CE) and the second cathode connection line (CCE2) comprises:
covering, by the second cathode connection line (CCE2), the dummy dam (DUM) entirely; and
forming the second cathode connection line (CCE2) and the cathode electrode (CE) integrally with each other.

10. The method according to claim 9, wherein:
the patterning of the second pixel definition layer (PDL2) and the dummy dam (DUM) comprises performing an exposure process using a photomask (MAS) comprising a full tone part (FP) and a middle part (MP),
a position of the full tone part (FP) corresponds to a position of the second pixel definition layer (PDL2),
a position of the middle part (MP) corresponds to a position of the dummy dam (DUM), and
the performing of the exposure process comprises forming a photoresist layer comprising a negative type photoresist.

11. The method according to claim 9 or 10, wherein:
a cross-section of the dummy dam (DUM) has a normal-tapered shape,
a cross-section of the first pixel definition layer (PDL1) has a normal-tapered shape, and
a cross-section of the second pixel definition layer (PDL2) has a reverse-tapered shape.

12. The method according to claims 9 to 11, wherein:
the patterning of the second pixel definition layer (PDL2) comprises patterning a plurality of second pixel definition layers (PDL2) spaced apart in the first direction (DR1), and
the forming of the light-emitting part (EL) comprises providing ink (INK) comprising material associated with forming the light-emitting part (EL) between the plurality of second pixel definition layers (PDL2).

13. The method according to claims 9 to 12, wherein:
the forming of the second cathode connection line (CCE2) comprises disposing the second cathode connection line (CCE2) such that the second cathode connection line (CCE2) is directly adjacent to the dummy dam (DUM), and
the forming of the cathode electrode (CE) comprises disposing the cathode electrode (CE) such that the cathode electrode (CE) is directly adjacent to the first pixel definition layer (PDL1).

14. The method according to claims 9 to 13, wherein the patterning of the first cathode connection line (CCE1) and the forming of the cathode electrode (CE) and the second cathode connection line (CCE2) comprise forming, by the cathode electrode (CE), the first cathode connection line (CCE1), and the second cathode connection line (CCE2), a cathode signal path.

15. An electronic device (1000), comprising:
a processor (1010) configured to provide input image data;
a display device (1060, DD) configured to display an image based on the input image data; and
a power supply (1050) configured to supply power to the display device (1060, DD),
wherein:
the display device (1060, DD) comprises:
a display area (DA) and a non-display area (NDA), the display device (1060, DD) comprising:
a base layer (BSL) which is disposed across the display area (DA) and the non-display area (NDA);
a light-emitting element (LD) which is disposed on the base layer (BSL) in the display area (DA) and comprises an anode electrode (AE), a cathode electrode (CE), and a light-emitting part (EL) electrically connected between the anode electrode (AE) and the cathode electrode (CE);
a first pixel definition layer (PDL1) and a second pixel definition layer (PDL2) which are disposed on the base layer (BSL) in the display area; and
a dummy dam (DUM) which is disposed on the base layer (BSL) in the non-display area (NDA) and surrounds at least a portion of the display area (DA),
the first pixel definition layer (PDL1) extends in a first direction (DR1), and the second pixel definition layer (PDL2) extends in a second direction (DR2) different from the first direction (DR1),
the light-emitting part (EL) is disposed in an area surrounded by the first pixel definition layer (PDL1) and the second pixel definition layer (PDL2),
a cross-section of the second pixel definition layer (PDL2) has a reverse-tapered shape, and
a cross-section of the dummy dam (DUM) has a normal-tapered shape.
